# EUROPEAN PATENT APPLICATION

(11) **EP 4 614 808 A1**
(43) Date of publication of application: **10.09.2025**
(21) Application number: 23923769.6
(22) Date of filing: 15.11.2023
(51) Int. Cl.: H02S 30/10

(54) **PHOTOVOLTAIC MODULE HAVING LIGHTWEIGHT FRAMES, AND MANUFACTURING METHOD THEREFOR**

(30) Priority: 23.02.2023 CN 202310159963
(71) Applicant: Cannnovation Photoelectric Technology Co., Ltd, Changzhou, Jiangsu 213000 (CN)
(72) Inventor: SUN, Quan, Hangzhou, Jiangsu 213000 (CN)
(74) Representative: ABG Intellectual Property Law, S.L.
(86) International application number: PCT/CN2023/131737
(87) International publication number: WO 2024/174606

(57) **Abstract**

A photovoltaic module having lightweight frames, and a manufacturing method therefor. The photovoltaic module having lightweight frames comprises a module body (2) and L-shaped frames (1), the L-shaped frames (1) and the module body (2) being bonded by means of an encapsulating material (4) overflowing the module body (2). The manufacturing method therefor comprises: before the module is laminated, assembling the L-shaped frames (1) and a laminate member together, so as to obtain a member to be laminated; and then laminating the member to be laminated so as to encapsulate the module and the bond the L-shaped frames (1) and the module body (2). The L-shaped frame (1) protects a side edge of the module, has a light weight, and satisfies the lightweight requirements of the module. The L-shaped frame (1) does not affect the module lamination, and the frame (1) can be bonded by means of the encapsulating material (4) overflowing the module body (2) during lamination, thus saving the use of silicone and equipment investment and greatly reducing the overall cost.

## Description

### TECHNICAL FIELD

The present application relates to the technical field of photovoltaic assembly, and in particular to a photovoltaic assembly with a lightweight frame and a preparation method therefor.

### BACKGROUND ART

With the development of photovoltaic technology, the cost of the assembly is gradually reduced. However, a reduced range of the frame cost is limited due to the limitation of aluminum material, which results in the frame accounting for a high cost among the assembly. Furthermore, the frame of the existing structure is heavy, and the current lightweight assembly adopts a frameless design in order to realize a lightweight. In actual use, however, since the assembly glass lacks protection at the side surface, the edge of the assembly glass is easily broken, which results in that the assembly is scrapped.

The existing assembly frame is mounted after the assembly is laminated, and the assembly frame is bonded to the assembly body by injecting the silicone into the assembly frame.

The existing assembly frame generally includes a top edge of the frame (also referred to as an A side), a side edge of the frame (also referred to as a B side), and a bottom edge of the frame (also referred to as a C side), which wrap around a light-receiving surface edge, side surface, and dark surface edge of the assembly body. The thickness of the A side of the assembly frame is generally 2mm. During long-term outdoor use, the dust and dirt are easily accumulated, which affects the power generation capacity of the assembly.

Through a search for the prior art, it was found in the prior art that the assembly frame with A side omitted exists for solving the problem of dust accumulation, such as those in Chinese patent document CN214256207U and Chinese patent document CN217949570U. However, the frame is still mounted after the assembly is laminated in the above prior art, and the assembly frame is still bonded to the assembly body by injecting the silicone into the assembly frame.

### SUMMARY

The technical problem to be solved by the present application is how to further simplify the framing process and reduce costs.

The technical solutions adopted by the present application to solve the technical problems are as follows. A photovoltaic assembly with a lightweight frame includes an assembly body and a frame located on a side edge of the assembly body, wherein the frame is an L-shaped frame; the L-shaped frame includes a bottom edge of the frame located on a dark surface of the assembly body and a side edge of the frame located on a side surface of the assembly body; and the L-shaped frame is bonded to the assembly body by a packaging material overflowing the assembly body.

Further, the packaging material overflowing the assembly body is provided between the side edge of the frame and the side surface of the assembly body and between a bottom edge of the frame and the dark surface of the assembly body for bonding the frame to the assembly body.

Further, the side edge of the frame is flush to a light-receiving surface of the assembly body, or the side edge of the frame is lower than the light-receiving surface of the assembly body, wherein a height difference between them is ≤ 0.5mm.

Further, the L-shaped frame is made of a metal, which specifically includes aluminum and stainless steel; or the L-shaped frame is made of an organic material resisting high-temperature lamination, which specifically includes epoxy board, PC board, PP, and polyurethane.

Further, the L-shaped frame is a solid structure or a hollow structure, and an inner sidewall of the L-shaped frame is a plane or a non-planar surface with a groove and/or a convex rib.

Further, a thickness of the side edge of the frame is between 0.1~5mm; a thickness of the bottom edge of the frame is between 0.1~3mm, and a width of the bottom edge of the frame is between 1~20mm; and a length of the L-shaped frame is between 10mm~3000mm, wherein the L-shaped frame is equal in length to the corresponding side edge of the assembly body; or the L-shaped frame is a short frame, and a length of which is shorter than a length of the corresponding side edge of the assembly body.

Further, all or partial side edges of the assembly body are provided with the L-shaped frames.

Further, the packaging material within the assembly body is an EVA adhesive, a POE adhesive, an EPE adhesive, a PVB adhesive, or a PEP adhesive, etc.

Further, the frame is in the form of a single frame; or, the frame is a combination frame combined by at least two frames.

A preparation method for a photovoltaic assembly with the lightweight frame above is performed, including assembling the L-shaped frames with a stacking member before laminating the assembly, so as to obtain a to-be-laminated member; and then laminating the to-be-laminated member, so that the assembly is packaged and the L-shaped frame is bonded with the assembly body.

Further, the L-shaped frames are assembled with the stacking members by a fixing action of a temporary fixture.

Further, it includes the following steps.
(1) Stacking the assembly: stacking structures of each layer of the assembly body to obtain the stacking member.
(2) Framing: assembling the L-shaped frames to a side surface of the stacking member, and temporarily fixing the L-shaped frames by the temporary fixture, so as to obtain the to-be-laminated member by the assembling.
(3) Laminating the assembly: laminating the to-be-laminated member, wherein the overflowing packaging material enters a gap between the frame and the assembly body during a laminating process, so as to package the assembly and bond the L-shaped frame with the assembly body.
(4) Post-treatment after laminating: performing a subsequent preparation of the assembly, and removing the temporary fixture in this step.

Further, the temporary fixture is a tape.

Further, the tape is specifically a high-temperature resistant tape, wherein a heat resisting temperature is not lower than a laminating temperature.

In addition to assembling with the stacking member by the fixing action of the temporary fixture, the frame can be assembled with the stacking member by its own structure. For example, the method includes combining and fixing the L-shaped frames together first, and then sleeving the L-shaped frames combined and fixed together on the stacking member, so as to assemble the L-shaped frames and the stacking member.

The present application includes the following beneficial effects. The L-shaped frame can protect the side edge of the assembly, and at the same time has a light weight, which meets a lightweight requirement of the assembly. The L-shaped frame does not have the A side, which avoids the problem that the dust accumulates on the front edge of the outdoor assembly, and improves the power generation capacity. The L-shaped frame does not have the A side, and at the same time the sizes of the B side and C side are also greatly reduced compared with the conventional frame, so that the cost of the frame is greatly reduced. The L-shaped frame does not affect the laminating for the assembly, and the frame can be bonded by the packaging material overflowing the assembly body when laminating, which omits the use of the silicone and the investment of the device, so that the overall cost can be greatly reduced.

### BRIEF DESCRIPTION OF DRAWINGS

The present application will be further illustrated below in conjunction with drawings and embodiments.
FIG. 1 is a structure schematic diagram of a frame of the present application;
FIG. 2 is an explosion diagram of an assembly of the present application;
FIG. 3 is a localized structure schematic diagram of a to-be-laminated member when laminating the present application;
FIG. 4 is a localized structure schematic diagram of a to-be-laminated member after laminating FIG. 3;
FIG. 5 is a structure schematic diagram of a light-receiving surface of an assembly of the present application;
FIG. 6 is a structure schematic diagram of a dark surface of an assembly of the present application;
FIG. 7 is a structure schematic diagram of a light-receiving surface of a short-frame assembly of the present application; and
FIG. 8 is a structure schematic diagram of a dark surface of a short-frame assembly of the present application.

Reference numbers: 1. frame; 1-1. side edge of the frame; 1-2. bottom edge of the frame; 2. assembly body; 2-1. front panel; 2-2. packaging material layer; 2-3. battery-sheet layer; 2-4. back plate; 3. high-temperature resistant tape; and 4. packaging material.

### DETAILED DESCRIPTION OF EMBODIMENTS

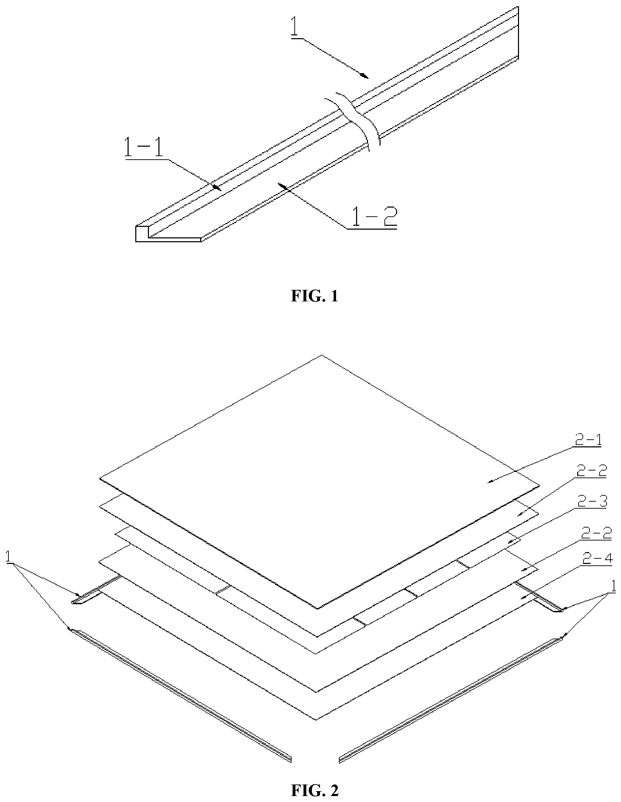

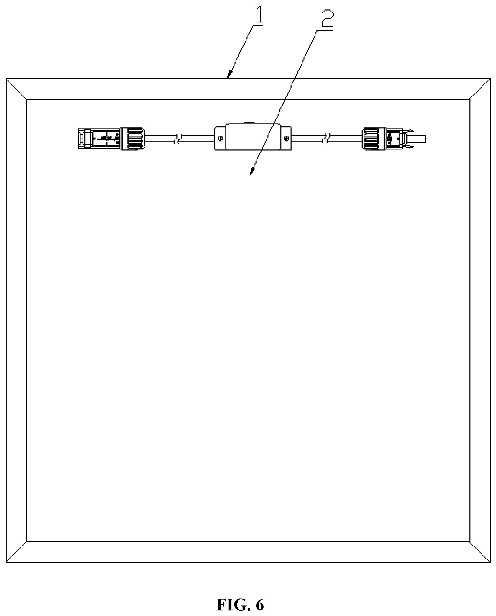

As shown in FIG. 1 ~ FIG. 6, a photovoltaic assembly with a lightweight frame includes an assembly body 2 and a frame 1 located on a side edge of the assembly body 2, wherein the frame 1 is an L-shaped frame; the L-shaped frame includes a bottom edge of the frame 1-2 located on a dark surface of the assembly body 2 and a side edge of the frame 1-1 located on a side surface of the assembly body 2; and the L-shaped frame is bonded to the assembly body 2 by a packaging material 4 overflowing the assembly body 2.

In this text, the stacking member is a generic term of structures of each layer of the assembly before laminating, and the assembly body is a generic term of structures of each layer of the assembly after laminating.

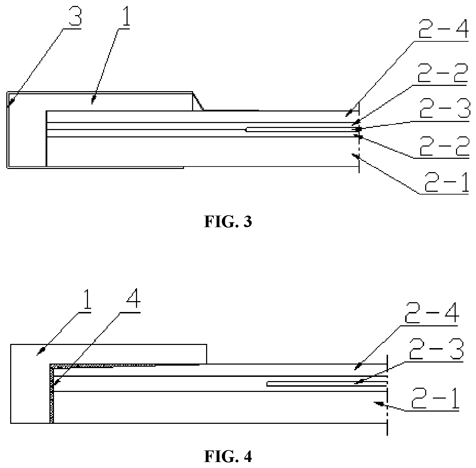

As shown in FIG. 4, the packaging material 4 overflowing the assembly body 2 is provided between the side edge of the frame 1-1 and the side surface of the assembly body 2 and between a bottom edge of the frame 1-2 and the dark surface of the assembly body 2 for bonding of the frame 1 to the assembly body 2.

The packaging material 4 within the assembly body 2 is an EVA adhesive or a POE adhesive, or of course can be other packaging materials used for assembly packaging, such as an EPE adhesive, a PVB adhesive, or PEP adhesive.

The side edge of the frame 1-1 is flush to a light-receiving surface of the assembly body 2, or of course, it can also be that the side edge of the frame 1-1 is slightly lower than the light-receiving surface of the assembly body 2, and a height difference between them is ≤ 0.5mm. Before laminating, the side edge of the frame 1-1 is lower than the stacking member. A thickness of the side edge of the frame 1-1 is between 0.1~5mm; a thickness of the bottom edge of the frame 1-2 is between 0.1~3mm, and a width of the bottom edge of the frame 1-2 is between 1~20mm.

The L-shaped frame is made of a metal, which specifically includes aluminum and stainless steel; or the L-shaped frame is made of an organic material resisting high-temperature lamination, which specifically includes epoxy board, PC board, PP, and polyurethane, etc.

As shown in FIG. 4, the L-shaped frame is a solid structure, and an inner sidewall of the L-shaped frame is a plane.

As shown in FIG. 2 and FIG. 3, the assembly body 2 includes a front panel 2-1, a packaging material layer 2-2, a battery-sheet layer 2-3, a packaging material layer 2-2, and a back plate 2-4.

In FIG.1~FIG. 6, four side edges of the assembly body 2 all have L-shaped frames. The frame 1 is in the form of a single frame. The bottom edges of the frames 1-2 of four frames 1 have the same width, or of course the bottom edges of the frames 1-2 can have different widths.

In FIG. 2, FIG. 5, and FIG. 6, each of the frames 1 are spliced at the splicing corners by means of cutting the corners. Of course, it also can splice by cutting off the overlapping part of one of the frames 1 at the splicing part.

The preparation method for the photovoltaic assembly with the lightweight frame includes the following steps.
(1) Stacking the assembly: stacking the structures of each layer of the assembly body 2 from bottom to top in order of the front panel 2-1, the packaging material layer 2-2, the battery-sheet layer 2-3, the packaging material layer 2-2, and the back plate 2-4 to obtain the stacking member.
(2) Framing: attaching the L-shaped frames to four edges of the stacking member and the dark surface and placing them to the side surface of the stacking member, and temporarily fixing the L-shaped frames by the temporary fixture, so as to obtain the to-be-laminated member as shown in FIG. 3. The temporary fixture is a high-temperature resistant tape 3, which can reliably fix the frame without obstructing the subsequent laminating step. The high-temperature resistant tape 3 generally covers from the side surface of the frame to the dark surface and the light-receiving surface of the stacking member, so as to ensure that the frame 1 is reliably and temporarily fixed.
(3) Laminating the assembly: placing the to-be-laminated member into a laminating machine for the normal press. The overflowing packaging material 4 will fill the gap between the frame 1 and the assembly body 2 during the laminating process, thereby bonding the L-shaped frame to the assembly body 2.
(4) Post-treatment after laminating: performing a subsequent preparation of the assembly after removing the high-temperature resistant tape 3. The subsequent preparation process is consistent with that of the normal assembly.

In step (4), the excess packaging material 4 overflowing the frame 1 needs to be removed at the same time when removing the high-temperature resistant tape 3 only if there is excess packaging material 4 overflowing the frame 1. The high-temperature resistant tape 3 and the excess overflowing adhesive can also be removed during the process of the subsequent preparation of any assembly without affecting the subsequent preparation of the assembly.

The L-shaped frame in the embodiment removes the top edge of the frame compared with the existing frame, which greatly reduces the height and thickness of the side edge of the frame 1-1 and reduces the width of the bottom edge of the frame 1-2, so as to greatly reduce the weight of the frame 1, which can greatly reduce the cost of the frame 1; and at the same time, removing the top edge of the frame can absolutely solve the problem of dust accumulation of the assembly. During the installation process of the frame 1, the frame 1 is bonded to four side edges of the assembly body 2 by using the high-temperature resistant tape 3 before laminating, wherein the frame 1 is fixed and installed by utilizing the adhesive overflowing outwardly from four edges when laminating the assembly, and the high-temperature resistant tape 3 and the excess overflowing adhesive are removed after laminating. This solution can simplify the framing process of the assembly, and omits the use of the silicone and the investment of the device, so that the overall cost can be greatly reduced.

The above is only the preferable embodiment of the present application, and the scope of protection of the present application is not limited to this. Equivalent substitutions or changes made by any technical person familiar with the technical field according to the technical solutions of the present application and the invention concept within the technical scope disclosed by the present application shall be covered by the protection scope of the present application.

For example, when assembling the L-shaped frame and the stacking member, it is not required to have to temporarily fix the frame 1 and the stacking member by using the temporary fixture. It can also combine and fix all frames 1 together by means of welding, bonding, or fastening with fasteners first to from the combination frame, and then sleeve the combination frame on the stacking member. The frame 1 will not separate from the stacking member when laminating the assembly even without the temporary fixture at this time, so that the temporary fixture can be omitted.

For example, the temporary fixture is also not limited to the high-temperature resistant tape 3. Any temporary fixture and fixing method can be adopted if the frame 1 and the stacking member can be temporarily fixed and the laminating of the assembly is not affected before laminating. When choosing the other temporary fixture, the steps of stacking the assembly and framing can be adjusted accordingly according to the temporary fixing method, and it is not limited to steps of the stacking the assembly first and then the framing.

For example, under the premise of ensuring the bonding strength, the packaging material 4 overflowing the assembly body 2 can be only provided between the side edge of the frame 1-1 and the side surface of the assembly body 2 or between the bottom edge of the frame 1-2 and the dark surface of the assembly body 2.

For example, the L-shaped frame is the hollow structure, and the inner sidewall of the L-shaped frame is the non-planar surface with the groove and/or the convex rib. The groove or the convex rib can play a role of reducing weight and serve as an adhesive holding groove.

For example, partial side edges of the assembly body 2 are provided with the L-shaped frames, and the rest side edges of the assembly body 2 are frameless. Specifically, for example, three edges of the assembly body 2 are provided with the L-shaped frames, and the rest edge is frameless.

For example, the lightweight frame in the photovoltaic assembly with the lightweight frame of the present application refers to the L-shaped frame omitting the A side of the present application. Besides the lightweight assembly, the solutions of the present application can be applied to the conventional assemblies, such as single-glass assembly, double-glass assembly, double-sided double-glass assembly, and flexible assembly.

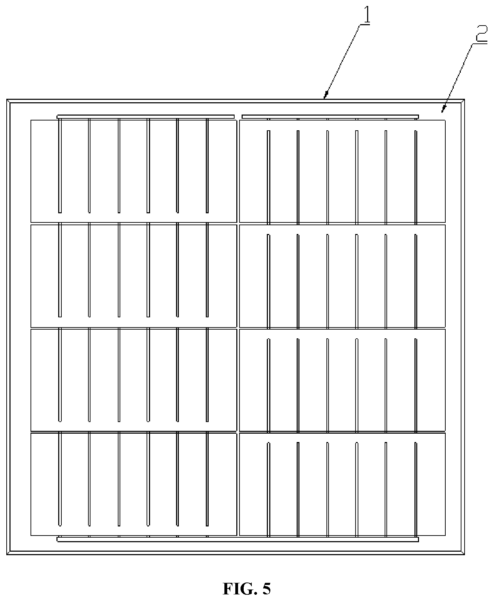

For example, besides in the form of a single frame, the frame 1 can further be a combination frame combined by at least two frames 1. Specifically, for example, it can be: combining and fixing two frames 1 in FIG. 5 to form a L-shaped combination frame, and then assembling with other frames; combining and fixing three frames 1 in FIG. 5 to form a combination frame, and then assembling with the other frame 1; or combining and fixing four frames 1 in FIG. 5 to form a combination frame matching the appearance and size of the assembly.

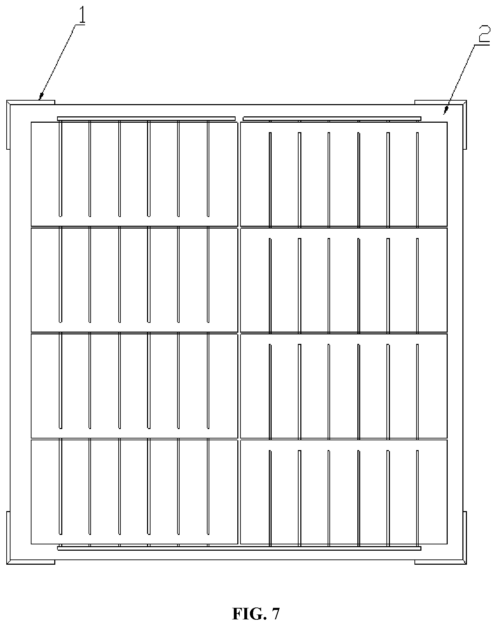

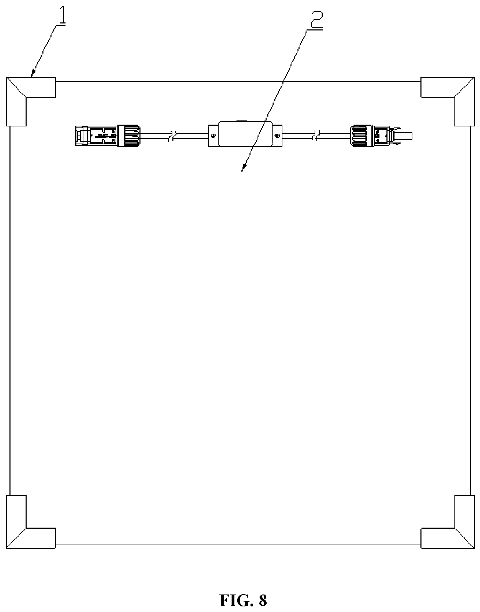

For example, the length of the frames 1 of the assembly can be set flexibly according to the requirement of the protection range of the assembly, and it can be longer or shorter, wherein the length of the frame 1 is generally between 10mm~3000mm. In FIG. 2, FIG. 5, and FIG. 6, the frame 1 is equal in length to the corresponding side edge of the assembly body 2, i.e. the frame 1 in the direction of the long edge is equal in length to the long edge of the assembly body 2, and the frame 1 in the direction of the short edge is equal in length to the short edge of the assembly body 2. However, as shown in FIG. 7 and FIG. 8, when it only needs to protect corners of the assembly, the frame 1 is the short frame and forms a protection corner at the corner of the assembly body 2.

## Claims

1. A photovoltaic assembly with a lightweight frame, comprising an assembly body (2) and a frame (1) located on a side edge of the assembly body (2), wherein the frame (1) is an L-shaped frame; the L-shaped frame comprises a bottom edge of the frame (1-2) located on a dark surface of the assembly body (2) and a side edge of the frame (1-1) located on a side surface of the assembly body (2); and the L-shaped frame is bonded to the assembly body (2) by a packaging material (4) overflowing the assembly body (2).

2. The photovoltaic assembly with the lightweight frame according to claim 1, **characterized in that** the packaging material (4) overflowing the assembly body (2) is provided between the side edge of the frame (1-1) and the side surface of the assembly body (2) and between a bottom edge of the frame (1-2) and the dark surface of the assembly body (2) for bonding the frame (1) to the assembly body (2).

3. The photovoltaic assembly with the lightweight frame according to claim 1, **characterized in that** the side edge of the frame (1-1) is flush to a light-receiving surface of the assembly body (2), or
the side edge of the frame (1-1) is lower than the light-receiving surface of the assembly body (2), wherein a height difference between the side edge of the frame (1-1) and the light-receiving surface of the assembly body (2) is ≤ 0.5mm.

4. The photovoltaic assembly with the lightweight frame according to claim 1, **characterized in that** the L-shaped frame is made of a metal comprising aluminum and stainless steel; or
the L-shaped frame is made of an organic material resisting high-temperature lamination comprising an epoxy board, PC board, PP, and polyurethane.

5. The photovoltaic assembly with the lightweight frame according to claim 1, **characterized in that** the L-shaped frame is a solid structure or a hollow structure, and an inner sidewall of the L-shaped frame is a plane or a non-planar surface with a groove and/or a convex rib.

6. The photovoltaic assembly with the lightweight frame according to claim 1, **characterized in that** a thickness of the side edge of the frame (1-1) is between 0.1~5mm; a thickness of the bottom edge of the frame (1-2) is between 0.1~3mm, and a width of the bottom edge of the frame (1-2) is between 1~20mm; and a length of the L-shaped frame is between 10mm~3000mm, wherein the L-shaped frame is equal in length to a corresponding side edge of the assembly body (2), or the L-shaped frame is a short frame and a length of the L-shaped frame is shorter than a length of the corresponding side edge of the assembly body (2).

7. The photovoltaic assembly with the lightweight frame according to claim 1, **characterized in that** all or partial side edges of the assembly body (2) are provided with the L-shaped frames.

8. The photovoltaic assembly with the lightweight frame according to claim 1, **characterized in that** the packaging material (4) within the assembly body (2) is an EVA adhesive, a POE adhesive, an EPE adhesive, a PVB adhesive, or a PEP adhesive.

9. The photovoltaic assembly with the lightweight frame according to claim 1, **characterized in that** the frame (1) is in the form of a single frame, or
the frame (1) is a combination frame combined by at least two frames.

10. A preparation method for the photovoltaic assembly with the lightweight frame according to any one of claims 1~8, comprising assembling the L-shaped frames with a stacking member before laminating the assembly, to obtain a to-be-laminated member; and then laminating the to-be-laminated member, so that the assembly is packaged and the L-shaped frames are bonded with the assembly body (2).

11. The preparation method for the photovoltaic assembly with the lightweight frame according to claim 10, **characterized in that** the L-shaped frames are assembled with the stacking member by a fixing action of a temporary fixture.

12. The preparation method for the photovoltaic assembly with the lightweight frame according to claim 11, comprising:
(1) stacking the assembly: stacking structures of each layer of the assembly body (2) to obtain the stacking member;
(2) framing: placing the L-shaped frames to a side surface of the stacking member, and temporarily fixing the L-shaped frames by the temporary fixture, so as to obtain the to-be-laminated member by assembling;
(3) laminating the assembly: laminating the to-be-laminated member, wherein the overflowing packaging material (4) enters a gap between the frame (1) and the assembly body (2) during a laminating process, so as to package the assembly and bond the L-shaped frames with the assembly body (2); and
(4) post-treatment after laminating: performing a subsequent preparation of the assembly, and removing the temporary fixture in this step.

13. The preparation method for the photovoltaic assembly with the lightweight frame according to claim 11 or 12, **characterized in that** the temporary fixture is a tape.

14. The preparation method for the photovoltaic assembly with the lightweight frame according to claim 13, **characterized in that** the tape is a high-temperature resistant tape (3), and a heat resisting temperature is not lower than a laminating temperature.

15. The preparation method for the photovoltaic assembly with the lightweight frame according to claim 10, comprising combining and fixing the L-shaped frames together first, and then sleeving the L-shaped frames combined and fixed together on the stacking member, so as to assemble the L-shaped frames with the stacking member.
